# EUROPEAN PATENT SPECIFICATION

(11) **EP 2 764 357 B1**
(45) Date of publication and mention of the grant of the patent: **22.04.2020**
(21) Application number: 12761657.1
(22) Date of filing: 11.07.2012
(51) Int. Cl.: G01N 30/60, B01D 15/22, B81C 1/00

(54) **METHOD FOR MAKING A SILICON SEPARATION MICROCOLUMN FOR CHROMATOGRAPHY OR GAS CHROMATOGRAPHY**
VERFAHREN ZUM HERSTELLEN EINER SILICIUMTRENNUNGSMIKROSÄULE FÜR CHROMATOGRAPHIE ODER GASCHROMATOGRAPHIE
PROCÉDÉ DE FABRICATION D'UNE MICROCOLONNE DE SÉPARATION EN SILICIUM POUR CHROMATOGRAPHIE OU CHROMATOGRAPHIE EN PHASE GAZEUSE

(30) Priority: 12.07.2011 IT BO20110414
(43) Date of publication of application: 13.08.2014
(73) Proprietor: Pollution S.r.l., 40054 Budrio (IT); Mancarella, Fulvio, 40129 Bologna (IT); Elmi, Ivan, 40129 Bologna (IT); Zampolli, Stefano, 40129 Bologna (IT); Poggi, Antonella, 40129 Bologna (IT); Cardinali, Giancarlo, 40129 Bologna (IT)
(72) Inventor: MANCARELLA, Fulvio, I-40129 Bologna (IT); ELMI, Ivan, I-40129 Bologna (IT); ZAMPOLLI, Stefano, I-40129 Bologna (IT); POGGI, Antonella, I-40129 Bologna (IT); CARDINALI, Giancarlo, I-40129 Bologna (IT); BELLUCE, Maddalena, I-40129 Bologna (IT); GALLI, Stefano, I-20025 Legnano (IT); GALLI, Mario, I-20025 Legnano (IT); BARAVELLI, Filippo, I-40054 Budrio (IT)
(74) Representative: Ruzzu, Giammario
(86) International application number: PCT/IB2012/053544
(87) International publication number: WO 2013/008191

(56) References cited:
- US-A- 5 690 841
- US-A- 6 093 330
- US-B1- 7 157 004
- ADARSH D. RADADIA ET AL: "Partially Buried Microcolumns for Micro Gas Analyzers", ANALYTICAL CHEMISTRY, vol. 81, no. 9, 1 May 2009 (2009-05-01), pages 3471-3477, XP055011054, ISSN: 0003-2700, DOI: 10.1021/ac8027382
- TJERKSTRA R W ET AL: "Etching technology for chromatography microchannels", ELECTROCHIMICA ACTA, ELSEVIER SCIENCE PUBLISHERS, BARKING, GB, vol. 42, no. 20-22, 1 January 1997 (1997-01-01), pages 3399-3406, XP004086710, ISSN: 0013-4686, DOI: 10.1016/S0013-4686(97)00193-X
- Upchurch Scientific: "NanoPort Assemblies", Instructions for Use , 2008, page 1, XP002662648, UPCHURCH SCIENTIFIC Retrieved from the Internet: URL:http://www.upchurch.com/PDF/I-Cards/N4 .PDF [retrieved on 2011-11-02]
- KOCH COREY, INGLE JAMES, REMCHO VINCENT: "Chips & Tips: Bonding Upchurch Nanoports to PDMS", Lab on a chip, 12 February 2008 (2008-02-12), pages 1-3, XP002662649, RCS publishing Retrieved from the Internet: URL:http://www.rsc.org/Publishing/Journals /lc/Chips_and_Tips/nanoport_bonding.asp [retrieved on 2011-11-02]
- MEINT J DE BOER ET AL: "Micromachining of Buried Micro Channels in Silicon", JOURNAL OF MICROELECTROMECHANICAL SYSTEMS, IEEE SERVICE CENTER, US, vol. 9, no. 1, 1 March 2000 (2000-03-01), XP011034541, ISSN: 1057-7157
- TJERKSTRA R W ET AL: "Etching technology for microchannels", PROCEEDINGS / MEMS 97 : THE TENTH ANNUAL INTERNATIONAL WORKSHOP ON MICRO ELECTRO MECHANICAL SYSTEMS ; AN INVESTIGATION OF MICRO STRUCTURES, SENSORS, ACTUATORS, MACHINES AND ROBOTS, NAGOYA, JAPAN, JANUARY 26-30, 1997, IEEE SERVICE CENTER, PISCATAWAY,, 26 January 1997 (1997-01-26), pages 147-152, XP010216895, DOI: 10.1109/MEMSYS.1997.581790 ISBN: 978-0-7803-3744-2

## Description

### Technical Field

The present invention relates to a silicon separation microcolumn for chromatography or gas chromatography.

In particular, the above mentioned column is aimed at being introduced in a chromatographic or gas-chromatographic system for analyzing gas in traces, that integrates, besides the separation column, all the functional blocks necessary for its operation.

Later on, reference will be made only to a column for gas chromatography, it being understood that most of the observations made previously are valid and/or can be applied also to a column for liquid chromatography, as far as they are conceptually compatible.

### Background Art

Since the gas chromatographic technique has been known for a long time, it will not be described in the following, where more attention will be paid to the instruments for its carrying out.

The gas chromatographic system includes, amongst other things, three main components:
1. an injector aimed at injecting a gas mixture to be analyzed, sucked by means of a sampling pump and introduced into the chromatographic column;
2. the separation column, which is aimed at separating the analytes forming the gas mixture on the basis of their interactions with the stationary phase (SP) present inside the column;
3. the detector aimed at quantifying the concentration of analytes leaving the column by supplying a suitable electric signal (voltage or current).

The analytes are carried along the column by means of an inert gas (for example, nitrogen, helium or hydrogen). The gas must not be reactive to the sample nor to the stationary phase and is defined mobile phase (MP)

The analytes pass through the column in different times, depending on the intensity of interaction with the stationary phase, and leave the column at different times and in quantities specific to each of them.

The detector plots a graph corresponding to the generated electric signal that correlates the detector response to the time, creating the so-called chromatogram.

Consequently, the core of a chromatographic system is constituted by the separation column. The present patent application will take into consideration only the separation column. The conventional gas chromatography (GC) typically uses two types of column: packed and capillary *(open tubular columns, OTC).*

The packed columns are made with tubes of glass or metal (for example stainless steel, copper, aluminium) or of teflon; generally they have a length (L) included between 1 and 6 m and an internal diameter in the range of 2 to 5 mm. They are filled with the stationary phase (SP) composed of a solid uniform and finely subdivided material, or with a solid support covered by a thin layer of the liquid stationary phase (thickness in a range of 0.05 to 1µm).

The introduction process of the SP into a column is called functionalization.

The *OTC* columns are formed of a capillary tube made of steel or glass or silica, normally having a length of 10-100 m and an inner diameter of about 0.1-1.00 mm. The inner walls of the column are covered with the stationary phase in the form of film, which is made adhere thereto and has a thickness of few tenths of micron, so as to cover the inner surface of the capillary tube in a uniform way.

The need to reduce the duration of the gas chromatographic analysis has resulted in manufacturing OTC columns that have a reduced inner diameter, usually of 50-100 µm and a reduced length, in the range of 2 to 10 m. The use of these columns aims at obtaining a quick analysis (called FAST-GC) without jeopardizing its resolving capability.

The conventional gas chromatographs require long analysis times, are difficult to use, require highly skilled staff and are very expensive.

For example, for the environmental analysis a sample of air to be analyzed is taken (using a "bag") and transferred to the laboratory where the results are obtained by means of counter instruments after a few days.

Moreover, the conventional systems are bulky and include brittle elements which makes it practically impossible to use them out of the laboratory environment.

The miniaturization of the components of a gas chromatograph allows reducing the volume of the gas necessary for the analysis as well as the volume of the carrier gas.

It results in the drastic reduction of the analyses duration and the increase of the chromatographic resolution.

The development of the silicon micro-machining technologies, modified by the microelectronics, has allowed the beginning of the so-called MEMS (Micro Electro Mechanical Systems), miniaturized devices that combine electric, electronic, micro-fluidic and micromechanical functionalities. Examples known to those skilled in the art include: inertial sensors for the airbags in the car industry field, the ink-jet heads for printers and the read/write heads of the hard disks. The MEMS technologies allow also to obtain miniaturized components of a GC system useful for the production of systems for the FAST GC.

In particular, the reduction of volumes, obtained with the help of micro-machined silicon columns, allows a reduction in the flow of the carrier gas, thus enabling the development of portable systems that use cylinders of smaller dimensions. This makes it possible to propose solutions for applications which require *in situ* analysis and in which the response times are of essential importance, such as industrial, environmental and hospital safety.

Examples of this type of columns, which are defined microcolumns, can be found in the publications WO 2005/121774 and WO 2009/135115.

The WO 2005/121774 describes a microcolumn obtained by the use of a silicon wafer, in which micro-trenches, made by known etching techniques, extend along paths that allow to obtain a single channel as long as possible. A sheet of glass is laid onto the silicon wafer, adhering thereto, so as to cover the micro-trench and obtain in this way a closed channel that forms the separation column, microcolumn actually.

As it appears from the figures of the above-mentioned publication, the micro-trench has a quadrangular or rectangular section, which is the simplest solution to be manufactured by the known technologies.

However, if on one hand these sections facilitate the production process, on the other hand, they cannot be considered optimal from the analytical point of view.

The quadrangular section presents problems related to the functionalization, that is the application of the stationary phase, likewise obtained by the known deposition techniques and consequently, not described herein. Actually, along the channel corner areas, the layer of the stationary phase is not uniform, which results in the loss of efficiency and resolution.

A solution to the above-mentioned problem is described in the WO 2009/135115, which illustrates the preparation of two micro-trenches having approximately semicircular section in two separated wafers. The cuts on the two silicon wafers are made with an isotropic etching, based on a solution of hydrochloric acid, nitric acid and acetic acid.

The micro-trenches extend according to a mirror pattern on the two wafers.

Subsequently, the two wafers are coupled taking care that the two semicircular micro-trenches mate. The stationary phase, that must cover the micro-trenches walls, can be deposited either before or after the coupling, using in both cases known deposition techniques.

In this way, a channel having an approximately circular section is obtained, having for example a serpentine arrangement and aimed at forming the separation microcolumn of the gas chromatographic system.

It is obvious that having the two semicircular micro-trenches mate is considerably difficult, especially in view of the extreme accuracy required, due to the dimensions involved. Being it matter of micrometers, even a very small variation from the position of the micro-trench of one of the wafers, or of a part thereof, with respect to the micro-trench of the other wafer, makes the trenches stagger.

Consequently, there are critical points in correspondence to the interface between the two wafers, points in which the problems of the square section columns are encountered too. In addition, separation lines between the relative stationary phase coatings remain along the obtained channel, along the interface between the two wafers. These separation lines cause problems and influence the gas sample being examined in a not uniform way, affecting adversely the times and quantities of analytes being output from the column.

Even the use of mechanical references (pins) has not allowed alignments to be obtained with errors smaller that an acceptable threshold.

Another problem relates to the fluidic interconnections of the microcolumn with the capillaries that are used for conveying the mixture of gas to be analyzed to the microcolumn and for conveying the analytes to the detector.

Normally, the outer surface of the silicon wafer/s, in which the microcolumn has been made, features holes that open into the micro-channel so as to allow the mixture to be introduced and the analytes to exit.

Normally, according to the known techniques, the capillaries are connected to the silicon wafers by means of a protruding edge, a kind of collar, provided at their ends and bonded by adhesion, using suitable glues, to the silicon wafer surface, placing the capillary duct in the region of the inlet or outlet hole. This collar is usually made of polymeric materials, different from those used for producing the capillary (silica coated with polyamide), which is fixed to the collar with mechanical grips, possibly helped by seals and glues.

Even though it is simple, this technique involves certain disadvantages and problems, such as the difficulty to center precisely the capillary with respect to the holes.

As already said above, the dimensions applied are very small, therefore, a normally acceptable positioning error can jeopardize in a critical way the effectiveness of the connection and, consequently, of the whole device.

Furthermore, the so obtained connection is fragile and presents the same problems caused by the unevenness of the inner surface of the mixture path, already seen before in the case of misalignment between the sections that form the micro-channel. In this case, the unevenness can even determine a variation of the duct section area, which, although limited to a short piece within the collar, can cause undesired effects for the correct functionalization of the microcolumn as well as for its optimal operation.

Again, this connection mode is not suitable for the temperatures, sometimes peculiar, of the operative method, which often exceed 150°C.

The risk of detachment, even only partial, or melting of the glues jeopardizes the operation stability and accuracy of the gas-chromatographic module, and therefore, it limits the module use only to those situations, in which the temperatures remain limited.

Consequently, this type of connection does not allow the module to be used, for example, in many of the apparatuses which are already in operation or are present on the market, thus limiting its use only to compatible apparatuses.

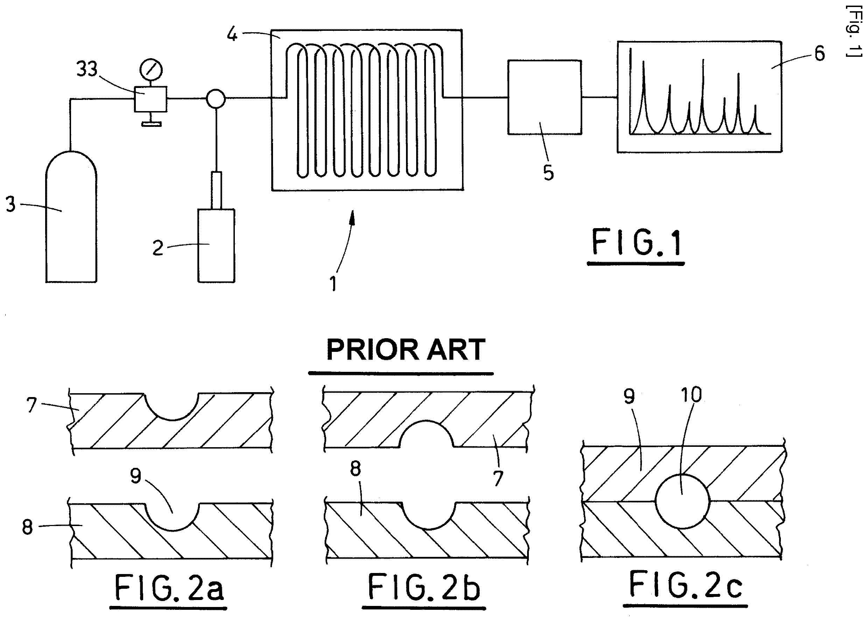

Figure 1 illustrates a gas chromatographic system which is normally used for the analysis of gas in traces, according to known techniques. In particular, the system includes the separation column 4, through which a flow of inert gas, called mobile phase (hydrogen, helium, nitrogen or others), is normally made to pass, it being supplied by a source 3 and adjusted by the adjusting device 33, and an injector 2, aimed at introducing a known volume of the gas to be analyzed into the previously mentioned flow in the beginning of the gas chromatographic measure.

The gas chromatographic microcolumn 4 is aimed at separating the analytes that compose the gaseous mixture on the basis of their interactions with the stationary phase present inside the column 4.

The detector 5, situated at the outlet of the column 4, is capable of quantifying the concentration of the analytes eluted from the column 4, supplying a suitable electric signal.

A diagram traced as a function of time, defined chromatogram 6, is constructed on the basis of the supplied electric signal.

Figures 2a, 2b, 2c show schematically the steps, in simplified form, of a known method, which uses the silicon micro-machining processes for the production of gas chromatographic microcolumn 4.

In this case and in the following, for the explanation simplicity's sake, reference will be made to the depictions with only one groove or channel in a portion of material, however, it being understood that more grooves or channels are made side by side on each wafer or layer of silicon, according to different known configurations, not relevant to the invention.

In the first step, shown in Figure 2a, a micro-trench having a semicircular section 9 is made on two layers of silicon 7, 8 by means of isotropic etching.

In the subsequent step, shown in Figure 2b, the upper layer of silicon 7 is overturned and centered with respect to the lower layer 8.

Finally, in the step shown in Figure 2c, the two layers are joined together by means of gluing or welding, in accordance with known techniques, not relevant to the present description.

According to this known method, the inner surface of the channel is coated with the separation stationary phase by chemical deposition known techniques, which can be carried out before or after that the two layers, which form the column, have been bonded together.

In both cases, a single block 9 of silicon is obtained, inside which the micro-channel 10 extends, having circular or nearly circular section, which however presents the disadvantages mentioned in the introductory note.

The document having title "Partially Buried Microcolumns For Micro Gas Analyzers" by Adarsh D. Radadia et Al., Analytical Chemistry, vol. 81, N. 9, 1st May 2009, pages 3471-3477, discloses a method of making partially buried microcolumns for gaschromatography having micro-channel with a rounded profile. This characteristic allows a more uniform stationary phase coating and, therefore, better separation properties for the columns.

As reported in the document, the described method has been used for making 34 cm long, 165 µm wide, and 65 µm deep partially buried microcolumns.

As stated by the same document, a unique rounded microcolumn wall profile similar to that of a flattened circular tube was obtained.

The same document states also that, currently, it is not known what wall profile a microcolumn should have for a better chromatographic performance.

The method includes the following steps:
making a micro-trench in a silicon wafer, by means of an silicon anisotropic etching process,
covering the side walls of said micro-trench by deposition of an oxide as a material resistant to isotropic etching,
effecting an anisotropic etching on this material at the bottom of the micro-trench, carrying out a silicon isotropic etching within the micro-trench, to obtain a silicon micro-channel having a flattened circular section. The micro-channel is then closed by means of a glass plate.

The micro-channel thus obtains is 165 µm wide, and 65 µm deep.

The same method is described, though not claimed, In the US Patent Application 2009/017 8563 A1.

The performance of the microcolumns obtained by the method just described, however, are not fully satisfactory, because the flattened shape of the micro-channel does not ensure a uniform distribution of the substance being analyzed.

Document US 6,093,330 discloses a process for fabricating enclosed, micron-scale subsurface coavities in a single crystal silicon substrate, including the steps of patterning the substrate to form vias, etching the cavities through the vias, and sealing the vias. A preferred embodiment includes closely spaced cavity pairs, separated by a thin membrane or merged to form an enlarged merged cavity having an overhanging bar to which electrical leads may be connected.

### Disclosure of Invention

### Technical Problem

The technical object of the present invention is to provide a method for producing microcolumns of silicon or/and glass, which permits columns to be obtained with one inner uniform wall, without discontinuity, interruptions and critical areas that have concentrated accumulation of the stationary phase, hence with a column profile perfectly circular or as far as possible circular.

Another object of the present invention is to provide a method for producing microcolumns, with technologies of the MEMS (Micro Electronic Mechanical Systems) type, for which it is easy to carry out the functionalization, that is the application of the stationary phase.

Still another object of the present invention is to provide a method for the production of microcolumns of silicon and/or glass, whose diameter can be determined within wider intervals, especially in a range of smaller diameters.

Yet another object of the present invention is to provide a method for the production of microcolumns of silicon and/or glass, which is much simpler with respect to the methods of the prior art.

A further object of the present invention is to provide a method which allows microcolumns to be obtained which can be easily adapted to existing apparatuses, both in terms of mechanical aspects and of operation temperatures, so as to be able to adopt the gas chromatographic systems provided with these columns in broad measure and without the need to renew those expensive systems.

In particular, it is an object of the present invention to provide a microcolumn that allows a simplified, safe and precise connection, with a regular surface, to the capillaries that convey the gas to be analyzed.

In general, the proposed method must aim at a considerable simplification of the production process of the chromatographic or gas chromatographic microcolumns, maintaining or even improving their performance and operation specifications with respect to the conventional capillary columns.

Another object of the present invention is to provide a microcolumn obtained in accordance with the claimed method, for which all the objects listed above are to be obtained with respect to the method itself.

### Solution to Problem

### Technical Solution

The above mentioned objects are all achieved by a method according to claim 1.

### Advantageous Effects of Invention

### Advantageous Effects

Other advantages, novelty characteristics and objects of the present invention will become obvious from the following detailed description of the invention, taken into consideration together with the enclosed drawings, most of which are schematic and which, as it is understood, are not traced to scale. In various Figures, all identical or almost identical components are indicated with only one number. For sake of clarity, not all the components are indicated in every figure, nor every component of every embodiment of the invention is illustrated where its illustration is not necessary for those skilled in the art to understand the invention.

### Brief Description of Drawings

### Description of Drawings

In the drawings:
Figure 1 shows a gas chromatographic system used normally for the analysis of gas in traces, as mentioned before;
Figures 2a, 2b, 2c show schematically and with simplified steps one of the methods for the production of gas chromatographic microcolumns in accordance with the prior art, likewise described in the introductory note;
Figures 3a, 3b, 3c, 3d, 3e show schematically the method proposed by the present invention for the production of chromatographic or gas chromatographic microcolumns;
Figure 4 shows a detail of the gas chromatographic microcolumn obtained with the present invention, related to the solution adapted in order to incorporate the gas inlet/outlet connections in the same system.

### Best Mode for Carrying out the Invention

### Best Mode

The inventors have devised that to obtain better performance, a column should have been realized having a perfectly circular profile, or a profile as circular as possible.

Experimental findings have surprisingly confirmed that this intuition was correct.

The method for the production of micro-machined silicon columns in accordance with the present invention is divided in different substantial steps.

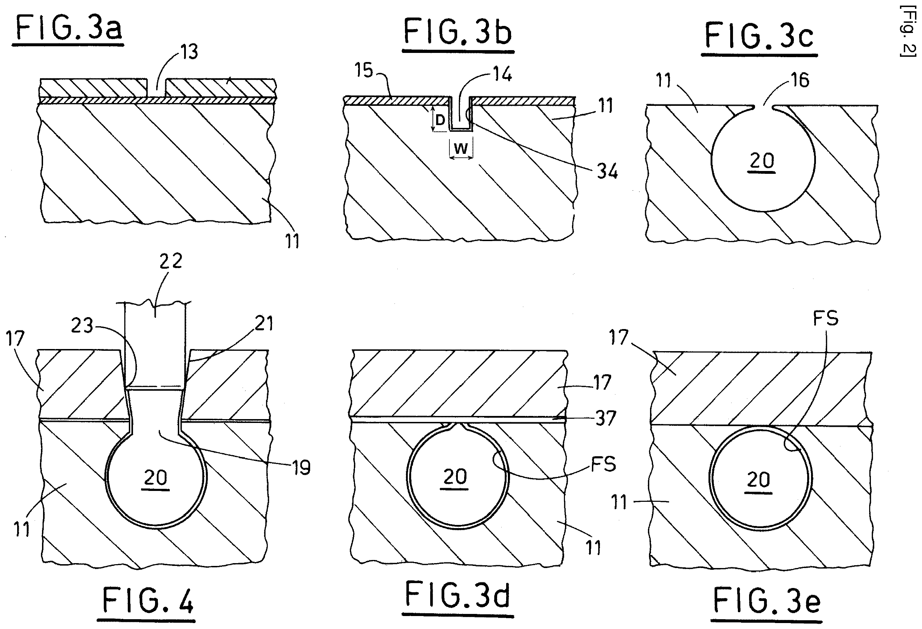

The first step includes the application, by masking, of a protection material 15, that resists the silicon erosion processes, applied on a wafer of silicon 11, as shown in Figure 3a, so as to leave uncovered only one strip 13 (for example, a 20 µm wide strip) that extends along the path which the microcolumn must follow.

Afterwards, in the next step, shown in Figure 3b, a micro-trench 14 is made by means of anisotropic etching with high density reactive plasma (DRIE-Bosch process). The micro-trench 14, having a square or almost square section, extends in depth in the silicon wafer 11, for different microns (for example, 20 µm).

In order to obtain a perfectly circular micro-channel, the inventors have thought to make the micro-trench 14 with a width-to-depth ratio in a range of 0,9 to 1,1. Actually, in order to obtain a micro-channel having a perfectly circular or as circular as possible profile, the ideal width-to-depth ratio of the micro-trench 14 is 1.

Then, the side walls of the micro-trench 14 of the wafer 11 are covered with a layer of material resistant to isotropic etching.

The protection of the lateral walls of the micro-trench 14 by deposition of a material resistant to isotropic etching includes the application of a layer 34 of polycrystalline silicon onto the walls of the micro-trench 14, the oxidation of this layer 34 of polycrystalline silicon and carrying out an anisotropic etching directed to the bottom of the micro-trench 14, so as to have it uncovered.

The protection with a layer of material 34 must resist the silicon etch process to be carried out in the subsequent step, shown in Figure 3c. This step includes an isotropic etching that uses high density plasma, and is carried out in depth of the micro-trench 14, until a micro-channel 20 is obtained having a perfectly circular profile and tangent to the upper surface of the silicon wafer 11.

The protection layers 15 and 34 are removed in order to finish the process and further reduce the unevenness and discontinuities.

In practice, after this step, as shown in Figure 3d, only a limited open space 16 remains along the upper part of the micro-channel 20, sufficient to possibly allow, according to a first embodiment of the present invention, the functionalization of the microcolumn, that is the application of the stationary phase FS, to be carried out. However, the width of the open space 16 is not sufficient to create corners or fissures that involve problems and affects the sample of gas, which is examined in a not uniform way, also affecting adversely the times and quantities of analytes output from the microcolumn.

The final step, shown in Figure 3d, includes the preparation of a second silicon wafer 17 that acts as a "cap" (*cap wafer*) or cover.

The bonding of the two wafers 11 and 17 is obtained, for example, by fusion bonding, a known technique used for bonding two silicon wafers, but there are also many other techniques, such as eutectic bonding or anodic bonding, depending on the materials that form the layers to be bonded.

The microcolumn obtained in accordance with this process has a circular geometry (for example, with an inner diameter of 100 micron) and a length of, for example, 2 m.

Besides its function of sealing the micro channel, the cap wafer, or cap or cover 17, includes also the sample inlet and outlet holes 21, as shown in Figure 4.

These holes 21 are obtained by conical through holes, having known conicity, produced by the silicon etch carried out by high density reactive plasma with DRIE technique, and are orthogonal to the wafer 11 face. Furthermore, they correspond to suitable openings 19 made in the underlying wafer 11.

The fluidic interconnections of the capillaries 22, that convey the mixture to be analyzed, with the microcolumn, have been obtained by the introduction of the ends 23 of the capillaries 22 into the conical holes 21 of the wafer 17 and a so-called press-fit coupling. The so obtained coupling can be further sealed with a polyamide resin in order to assure the tightness.

This connection allows also the gas-chromatographic module to support high temperatures, over 150°C, which is not possible with the connections with microcolumns obtained in accordance with the prior art including the collar connections, made for example of polymeric material, in this case imposing a considerable limitation of the module use to the conditions, in which the operation temperature does not exceed strictly limited values.

According to an advantageous variation, it is possible to provide a further technology for obtaining the cap or cover 17, in accordance with which this is obtained by a deposition of silicon, silicon oxide or a polymers on the silicon wafer.

The cap wafer 17 can be made not only of silicon, but also of silicon oxide (glass) and, in case it has been substituted with a layer obtained by deposition, the latter can be also made of a polymeric material, the whole with obvious advantages and remaining within the scope of the present invention.

In accordance with the first embodiment (Figure 3d), the functionalization is carried out before the application or formation of the cap or cover 17. If a layer of silicon or silicon oxide (glass) has been used, a layer 37 of stationary phase is applied, if necessary, also to the surface of such layer which is aimed at coupling with the silicon or glass wafer 11.

Whereas, in accordance with a second advantageous embodiment (Figure 3e), the functionalization is carried out as the last step, even after the application of the fluidic connections 22.

The last solution has the considerable advantage deriving from the fact that it can be carried out by known techniques for the capillary columns, in addition to making the layer of stationary phase still more uniform in the upper closure area of the micro-channel.

Also in the case of the second embodiment the variation can be carried out that includes the formation, by deposition, of a layer 17 of silicon, silicon oxide or a polymeric material on the wafer 11, through which the micro-channel 20 passes, instead of the layer of silicon or glass.

Independently from the embodiment that has been used or from the variation being applied, the obtained microcolumn is provided with means aimed at detecting and varying the operation temperature.

In particular, according to the modes known in the field, which will become obvious to those skilled in the art, temperature sensors are applied to the so obtained microcolumn, in determined areas. The sensors are not shown in the figures, since known to those skilled in the art.

Furthermore, a heater is applied to the column, likewise not shown, as of known type and not relevant to the present invention. The heater is aimed at supplying heat to the microcolumn so as to bring it and keep it at the desired operation temperature.

The heater and sensors are connected to suitable electronic control devices of known type, not shown.

The advantages and improvements obtained by adopting the method proposed by the present invention for the production of microcolumn for gas chromatography are evident.

Actually, the method under discussion provides columns with an inner uniform wall, without interruptions and corners and with a practically perfectly circular profile. This allows thickness unevenness and irregularities of the stationary phase surface to be avoided, which results in higher efficiency and better resolution of the separation microcolumn.

It will be appreciated that this advantage results from having made the micro-trench 14 with a width-to-depth ratio in a range of 0,9 to 1,1, and possibly with this ratio equal to 1.

In addition, the functionalization, that is the application of the stationary phase, is simplified and its correct distribution on the inner wall of the microcolumn is ensured.

The described method allows determination of the microcolumn diameter within wider intervals, especially in a range of diameters with smaller dimensions with respect to what is obtained with the prior art methods.

In general, the method allows the manufacture of microcolumns of silicon with greater simplicity and productivity with respect to the prior art methods.

The microcolumns obtained by the method of the present invention can be easily adapted to the existing apparatuses, both in terms of mechanical aspects and operation temperatures, due to the adoption of the press-fit interconnection system.

This advantage is particularly important, since it allows using gas chromatographic modules provided with these microcolumns in broad measure and without the need to renew expensive systems. This characteristic extends also to the microcolumn functionalization, which can be carried out using the same techniques and methods that are commonly used for the functionalization of the capillary silicon columns.

Moreover, the connection of the capillary ducts obtained in this way is simpler, safer and more precise, with a regular surface that does not hinder nor disrupt the transport of the gas to be analyzed.

In general, the proposed method tends to a considerable simplification of the process for the production of gas chromatographic microcolumns and provides a microcolumn that presents all the advantages listed before.

The Grob test has allowed an estimation of the microcolumn efficiency, that has resulted optimal, since its experimental efficiency, expressed by the number of theoretical plates (N), is bigger than 19000, a value which is very close to the theoretical efficiency (N) which is 20000.

As already said before, in the present description explicit reference has been made to a microcolumn for gas chromatography, however observations similar to those reported above, as far as conceptually compatible, can be made also in relation to a microcolumn for liquid chromatography, always made in accordance with the present invention. Although the present invention has been described with reference to its preferred embodiments, those skilled in the art will recognize the modifications that can be applied to the form and structure, without departing from the scope of the following claims.

## Claims

1. A method for making a separation microcolumn for a chromatographic or gas-chromatographic system, made in at least one silicon wafer (11), said method including the steps of:
application, by masking, of a layer of protection material (15), that resists silicon erosion processes, on said silicon wafer (11), so as to leave uncovered only one strip (13) that extends along the path which the microcolumn must follow;
making a micro-trench (14) by means of an anisotropic etching process onto said wafer (11), said micro-trench (14) extending in depth along the entire path of the microcolumn to be produced;
protecting the side walls of said micro-trench (14) by deposition of a layer of material (34) resistant to isotropic etching;
carrying out an in-depth isotropic etching within said micro-trench (14), to obtain a micro-channel (20) having a practically perfect circular profile tangent to the upper surface of the wafer (11);
closing the micro-channel by applying, onto the upper surface of said wafer (11), a layer of material (17) acting as a cover along the plane tangent to the micro channel (20), thereby closing said micro-channel (20);
carrying out the functionalization of said micro-channel (20);
said method realized by providing a width-to-depth ratio in the range of 0.9 to 1.1 for said micro-trench (14) and by removing said protection layers (15, 34) before closing said micro-channel (20) by application of said layer of material (17) acting as cover.

2. A method according to claim 1, wherein the width-to-depth ratio of said micro-trench (14) is 1.

3. A method according to any one of the claims 1 to 2, wherein the layer (17) acting as a cover consists of a further silicon wafer bonded to the wafer (11) by means of a wafer bonding process.

4. A method according to any one of claims 1 to 2, wherein the layer (17) acting as a cover consists of a silicon oxide wafer or glass wafer bonded to the silicon wafer (11) by means of a wafer bonding process.

5. A method according to any one of claims 1 to 2, wherein the layer (17) of material acting as a cover is obtained by means of a process for deposition of silicon, silicon oxide, glass or a polymeric material on the surface of the silicon wafer (11).

6. A method according to claim 3 or 4, wherein the functionalization is carried out also on the surface of said layer (17) of material acting as a cover aimed at coupling with said silicon wafer (11), and the functionalization of said micro-channel (20) is carried out before the step in which the micro-channel (20) is closed by applying, onto the upper surface of said silicon wafer (11), the layer of material (17) acting as a cover.

7. A method according to claims 1 to 6, wherein openings (19) are provided in the silicon wafer (11), which are in communication with said micro-channel (20), and inlet and outlet holes (21), having conical section, are provided in in the layer (17) acting as a cover, for the sample to be analyzed, which holes match with said openings (19) made in the silicon wafer (11) below; said inlet and outlet holes (21) being designed to receive, with a press-fit coupling, corresponding ends of capillaries (22) for the transport of the mixture to be analyzed.

8. A method according to claim 7, wherein the press-fit coupling obtained is further sealed with a polyamide resin to ensure tightness.

9. A method according to claims 1 to 8, wherein the step in which the side walls of said micro-trench (14) are protected by deposition of a material resistant to isotropic etching consists of: applying a layer (34) of polycrystalline silicon to said walls of said micro-trench (14), oxidizing said layer (34) of silicon, and carrying out an anisotropic etching directed to the bottom of said micro-trench (14), so as to have said bottom uncovered.

10. A separation microcolumn for chromatographic or gas-chromatographic system, made according to any one of claims 1 to 9.

11. A chromatographic or gas-chromatographic system including a separation microcolumn made according to any one of claims 1 to 9.

## Patentansprüche

1. Verfahren zur Herstellung einer Trennungsmikrosäule für ein chromatographisches oder gaschromatographisches System, die aus mindestens einem Silizium-Wafer (11) hergestellt ist, wobei diese Methode die folgenden Schritte umfasst:
Aufbringen einer Schicht aus Schutzmaterial (15), das einen Silizium-Erosionsprozessen widersteht, durch Maskierung auf die Silizium-Wafer (11), so dass nur ein Streifen (13) unbedeckt bleibt, der sich entlang des Weges erstreckt, dem die Mikrosäule folgen muss;
Herstellung eines Mikrograbens (14) durch einen anisotropen Ätzprozess auf dem Wafer (11), wobei der genannte Mikrograben (14) sich in der Tiefe entlang des gesamten Weges der herzustellenden Mikrosäule erstreckt;
Schutzen der Seitenwände des Mikrograbens (14) durch Abscheidung einer Schicht aus einem gegen isotropes Ätzen beständigen Material;
Durchführen einer isotropen Tiefenätzung innerhalb des Mikrograbens (14), um einen Mikrokanal (20) mit einem praktisch perfekten kreisförmigen Profil tangential zur oberen Oberfläche des Silizium-Wafers (11) zu erhalten;
Schließen des Mikrokanals durch Aufbringen einer Materialschicht (17), die als Abdeckung dient, auf die obere Oberfläche des Wafers (11) und entlang einer Ebene, die den Mikrokanal tangiert (20), wodurch der Mikrokanal (20) geschlossen wird;
Durchführung der Funktionalisierung des Mikrokanals (20);
wobei das Verfahren dadurch realisiert wird, dass ein Breiten-zu-Tiefen-Verhältnis im Bereich von 0,9 bis 1,1 für den Mikrokanal (14) bereitgestellt wird und dass die Schutzschichten (15, 34) vor dem Schließen des Mikrokanals (20) durch Aufbringen der als Abdeckung dienenden Materialschicht (17) entfernt werden.

2. Ein Verfahren nach Anspruch 1, wobei das Breiten-zu-Tiefen-Verhältnis des Mikro-Grabens (14) auf 1 beträgt.

3. Eine Methode nach einem der Ansprüche 1 bis 2, wobei die Schicht (17), die als Abdeckung dient aus einem weiteren Silizium-Wafer besteht, der mittels eines Wafer-Bonding-Prozesses mit dem Silizium-Wafer (11) verbunden ist.

4. Eine Methode nach einem der Ansprüche 1 bis 2, wobei die Schicht (17), die als Abdeckung dient, aus einem Siliziumoxid-Wafer oder Glaswafer besteht, der mittels eines Wafer-Bonding-Prozesses mit dem Silizium-Wafer (11) verbunden ist.

5. Ein Verfahren nach einem der Ansprüche 1 bis 2, wobei die Schicht (17) des Materials, das als Abdeckung dient, durch ein Verfahren zur Abscheidung von Silizium, Siliziumoxid, Glas oder einem polymeren Material auf der Oberfläche des Siliziumwafers (11) erhalten wird.

6. Ein Verfahren nach Anspruch 3 oder 4, wobei die Funktionalisierung auch auf der Oberfläche der Materialschicht (17), die als Abdeckung dient, durchgeführt wird, mit dem Ziel der Kopplung mit dem Silizium-Wafer (11), und die Funktionalisierung des Mikrokanals (20) vor dem Schritt des Verschließens des Mikrokanals (20) durchgeführt wird, indem auf die Oberseite des Silizium-Wafers (11) die Materialschicht (17), die als Abdeckung dient, aufgebracht wird

7. Eine Methode nach den Ansprüchen 1 bis 6, wobei Öffnungen (19) in der Silizium-Wafer (11) vorgesehen sind, die mit dem Mikrokanal (20) in Verbindung stehen, und Einlass- und Auslassöffnungen (21) mit konischem Querschnitt in der Schicht (17), die als Abdeckung dient, für die zu analysierende Probe vorgesehen sind, wobei die Löcher mit den Öffnungen (19) übereinstimmen, die in der Silizium-Wafer (11) unten gemacht wurden; wobei die Einlass- und Auslasslöcher (21) zur Aufnahme, mit einer Presspassungskupplung, entsprechende Enden von Kapillaren (22) für den Transport der zu analysierenden Mischung, vorgesehen sind.

8. Eine Methode nach Anspruch 7, wobei die erhaltene Pressverbindung zusätzlich mit einem Polyamidharz abgedichtet wird, um die Dichtheit zu gewährleisten.

9. Ein Verfahren nach den Ansprüchen 1 bis 8, wobei der Schritt, bei dem die Seitenwände des Mikrograbens (14) durch Abscheidung eines gegen isotropes Ätzen beständigen Materials geschützt werden, besteht aus: Aufbringen einer Schicht (34) aus polykristallinem Silizium auf die Wände des Mikrograbens (14), Oxidieren der Schicht (34) aus Silizium, und die Durchführung einer anisotropen Ätzung, die auf den Boden des Mikrograbens (14) gerichtet ist, so dass der Boden unbedeckt ist.

10. Trennmikrosäule für ein chromatographisches oder gaschromatographisches System, hergestellt nach einem der Ansprüche 1 bis 9.

11. Ein chromatographisches oder gaschromatographisches System einschließlich einer Trennmikrosäule nach einem der Ansprüche 1 bis 9.

## Revendications

1. Procédé de fabrication d'une microcolonne de séparation pour un système chromatographique ou chromatographique en phase gazeuse, réalisée dans au moins une plaquette de silicium (11), ladite méthode comprenant les étapes de:
application, par masquage, d'une couche de matériau de protection (15), qui résiste aux processus d'érosion du silicium, sur la plaquette de silicium (11), de manière à ne laisser à découvert qu'une bande (13) qui s'étend le long du chemin que doit suivre la microcolonne;
la réalisation d'une microtranchée (14) au moyen d'un processus de gravure anisotrope sur la plaquette (11), ladite microtranchée (14) s'étendant en profondeur sur tout le trajet de la microcolonne à produire;
protéger les parois latérales de la microtranchée (14) par le dépôt d'une couche de matériau résistant à la gravure isotrope;
la réalisation d'une gravure isotrope en profondeur dans la microtranchée (14), pour obtenir un microcanal (20) ayant un profil circulaire pratiquement parfait tangent à la surface supérieure de la plaquette de silicium (11);
fermer le microcanal en appliquant, sur la surface supérieure de la plaquette (11), avec une couche de matériau (17) qui sert de couverture le long de l'avion tangent au micro-canal (20), fermant ainsi le micro-canal (20);
la réalisation de la fonctionnalisation du micro-canal (20);
ledit procédé étant réalisé en fournissant un rapport largeur/profondeur dans la plage de 0,9 à 1,1 pour la microtranchée (14) et en retirant les couches de protection (15, 34) avant de fermer le microcanal (20) par application de la couche de matériau (17) agissant comme couverture.

2. Une méthode selon la revendication 1, dans lequel le rapport largeur/profondeur de la microtranchée (14) est de 1.

3. Une méthode selon l'une quelconque des revendications 1 à 2, dans lequel la couche (17) qui sert de couverture consiste en une autre plaquette de silicium liée à la plaquette de silicium (11) au moyen d'un procédé de liaison de plaquettes.

4. Méthode selon l'une quelconque des revendications 1 à 2, dans lequel la couche (17) qui sert de couverture consiste en une plaquette d'oxyde de silicium ou de verre liée à la plaquette de silicium (11) au moyen d'un procédé de collage de plaquettes.

5. Méthode selon l'une quelconque des revendications 1 à 2, dans lequel la couche (17) de matériau qui sert de couverture est obtenu par un procédé de dépôt de silicium, d'oxyde de silicium, de verre ou d'un matériau polymère sur la surface de la plaquette de silicium (11).

6. Une méthode selon la revendication 3 ou 4, dans lequel la fonctionnalisation s'effectue également sur la surface de la couche (17) de matériau qui sert de couverture visant à se coupler avec la plaquette de silicium (11), et la fonctionnalisation du microcanal (20) est effectuée avant l'étape de fermeture du microcanal (20) par l'application, sur la surface supérieure de la plaquette de silicium (11), de la couche de matériau (17) qui sert de couverture.

7. Une méthode selon les revendications 1 à 6, dans lequel des ouvertures (19) sont prévues dans la plaquette de silicium (11), qui sont en communication avec le micro-canal (20), et des trous d'entrée et de sortie (21), de section conique, sont prévus dans la couche (17) qui fait office de couvercle pour l'échantillon à analyser, dont les trous correspondent aux ouvertures (19) pratiquées dans la plaquette de silicium (11) ci-dessous; les trous d'entrée et de sortie (21) étant conçus pour recevoir, avec un raccord à pression, les extrémités correspondantes des capillaires (22) pour le transport du mélange à analyser.

8. Une méthode selon la revendication 7, dans lequel le raccord à pression obtenu est ensuite scellé avec une résine de polyamide pour assurer l'étanchéité.

9. Une méthode selon les revendications 1 à 8, dans lequel l'étape de protection des parois latérales de la microtranchée (14) par dépôt d'un matériau résistant à la gravure isotrope consiste à: appliquer une couche (34) de silicium polycristallin sur les parois de la microtranchée (14), oxyder la couche (34) de silicium, et en effectuant une gravure anisotrope dirigée vers le fond de la microtranchée (14), de manière à ce que le fond soit découvert.

10. Microcolonne de séparation pour système chromatographique ou gaz-chromatographique, réalisée selon l'une des revendications 1 à 9.

11. Système chromatographique ou chromatographique en phase gazeuse comprenant une microcolonne de séparation, fabriqué selon l'une quelconque des revendications 1 à 9.
